# EUROPEAN PATENT SPECIFICATION

(11) **EP 1 159 725 B1**
(45) Date of publication and mention of the grant of the patent: **26.03.2003**
(21) Application number: 99952862.3
(22) Date of filing: 24.09.1999
(51) Int. Cl.: G09F 9/35, G02F 1/1337, G02F 1/1345

(54) **DISPLAY AND BACKLIGHTING ASSEMBLY**
ANZEIGE UND HINTERGRUNDBELEUCHTUNGSVORRICHTUNG
ENSEMBLE ECRAN ET RETRO-ECLAIRAGE

(30) Priority: 24.09.1998 US 101681 P; 10.09.1999 US 393888
(43) Date of publication of application: 05.12.2001
(73) Proprietor: TELEFONAKTIEBOLAGET L M ERICSSON (publ), 126 25 Stockholm (SE)
(72) Inventor: EK, Martin, S-240 10 Dalby (SE); HEDEN, Erik, S-226 43 Lund (SE); SIMONSSON, Olof, S-222 29 Lund (SE); ANDERSSON, Magnus, S-211 50 Malmö (SE); DERRING, Mats, S-691 34 Karlskoga (SE); SANDELIUS, Thomas, S-217 42 Malmö (SE); JONSSON, Pernilla, S-212 14 Malmö (SE)
(74) Representative: HOFFMANN - EITLE
(86) International application number: SE9901682
(87) International publication number: WO00017840

(56) References cited:
- WO-A1-97/50014
- GB-A- 2 264 583
- US-A- 4 799 771
- US-A- 4 983 469
- US-A- 5 121 234
- US-A- 5 243 453

## Description

### BACKGROUND

The present invention relates to display assemblies for use with electronic devices, and more particularly to liquid crystal display assemblies suitable for use with compact, portable electronic devices.

Liquid crystal displays are widely used in the electronic industry on products ranging from cellular telephones, calculators and watches to computers and automobiles. Liquid crystal displays have many advantages over competing display technologies in areas such as size, cost, design flexibility, reliability, and power consumption. Such advantages make liquid crystal displays a popular choice for designers of electronic devices.

Liquid crystal material has properties of both liquids and solids. It is characterized by the property that the light transmission characteristics of a thin layer of liquid crystal may be altered by applying an electric field to the material. This property is exploited in a liquid crystal display.

Liquid crystal displays consist of a thin layer of liquid crystal material encased between a pair of thin glass plates. The inner surfaces of the glass plates are provided with transparent electrodes that define the patterns, characters or images to be displayed. The outer surfaces of the glass plates are provided with polarizing lenses. When a voltage is applied across a pair of corresponding electrodes, the display switches from opaque to clear at the location where the electrodes overlap, or vice versa, depending on the orientation of the polarizing lenses. The electrodes may be shaped and arranged into characters, segments, shapes or images, depending on the purpose and function of the display.

To control how the electrical signals are applied to the particular electrodes, the liquid crystal displays are electronically driven by a liquid crystal display driver. The liquid crystal display is usually physically attached to the driver board, which is physically attached to the protective cover. The cover and/or the driver board are then attached to the product to make the liquid crystal display assembly a device that is integral with the product as a whole.

In a reflective liquid crystal display, the display is illuminated solely by ambient light The liquid crystal display is backed by a reflective material which reflects ambient light back through the display. Reflective liquid crystal displays are ideally suited for low power applications in battery powered devices, as no power is needed to light the display. However, since reflective liquid crystal displays rely solely on ambient light for illumination, their brightness is limited. The brightness of a reflective liquid crystal display can be no greater than about 50%, where "brightness" is defined as the ratio of the luminance of the reflected light to the luminance of the transmitted light. Thus, reflective liquid crystal displays typically appear gray and are difficult to read in low light conditions.

The brightness of a liquid crystal display may be improved by backlighting the display. This is typically done by providing a light source such as a light-emitting diode behind the liquid crystal display. In this "transmissive" mode of operation, light from the light-emitting diode passes through the liquid crystal display where it is blocked or passed depending on the configuration and state of the various electrodes. However, light-emitting diode backlighting consumes a relatively large amount of power, since the light-emitting diode must continuously illuminate the display whenever the device is powered on.

Market forces continuously drive manufacturers to produce physically smaller, or compact, consumer electronic devices of high quality and durability and at lower costs. To meet these market demands, liquid crystal display assemblies must be of a compact and durable design, utilize a relatively small number of parts, and be readily manufacturable. Also, the advent of digital wireless networks has created the ability to transmit digital data to electronic devices, prompting the need for relatively larger displays on electronics devices.

International Publication Number WO 97/50014 describes an LCD assembly that includes a frame housing an LCD material layered on an electroluminescent material, which is in turn layered on a circuit board. One side of the circuit board includes elastomeric connectors to connect to the LCD material, the electroluminescent material on the other side of the circuit board, and to the main circuit board of a consumer product

### SUMMARY

The present invention addresses these and other needs by providing a low profile (e.g., thin) liquid crystal display assembly that offers a relatively large viewing area. Further, the liquid crystal display assembly of the present invention is easily assembled into a single, compact component that may be attached to a suitable electronic device such as, for example, a mobile phone. Further, the liquid crystal display of the present invention includes physical shock-absorbing features that contribute to the durability of the electronic device.

In one aspect, the invention provides a liquid crystal display assembly, comprising a carrier, a liquid crystal display secured adjacent the carrier, an electro luminescent film secured adjacent the liquid crystal display, a circuit board assembly secured adjacent the electro luminescent film, and a tape carrier package secured adjacent the circuit board and including circuitry for establishing an electrical connection between the liquid crystal display and the circuit board. The circuit board may be either a rigid printed circuit board or a flexible circuit board. A liquid crystal driver circuit is mounted to the tape carrier for generating electrical signals to power the liquid crystal display.

In another aspect, the invention provides a method of assembling a liquid crystal display assembly. The method comprises the steps of providing a liquid crystal display, adhering an electro luminescent film to a first side of the liquid crystal display, adhering a circuit board to the electro luminescent film, the circuit board having electrical connections for providing electrical signals to the liquid crystal display, and securing a tape carrier package adjacent the circuit board, the tape carrier package having circuitry for establishing an electrical connection between the liquid crystal display and the circuit board.

### BRIEF DESCRIPTION OF THE DRAWINGS

These, and other objects, features and advantages of the present invention will become more readily apparent to those skilled in the art upon reading the following detailed description, in conjunction with the appended drawings, in which:

Fig. 1 is an exploded, perspective view of a first embodiment of a liquid crystal display assembly in accordance with aspects of the present invention.

Fig. 2 is a perspective view of an assembled liquid crystal display assembly in accordance with the embodiment depicted in Fig. 1.

Fig. 3 is an exploded, perspective view of a second embodiment of a liquid crystal display assembly in accordance with aspects of the present invention.

Fig. 4 is a perspective view, taken from above, of an assembled liquid crystal display assembly in accordance with the embodiment depicted in Fig. 3.

Fig. 5 is a perspective view, taken from below, of a flexible printed circuit board in accordance with the embodiment depicted in Fig. 3.

### DETAILED DESCRIPTION

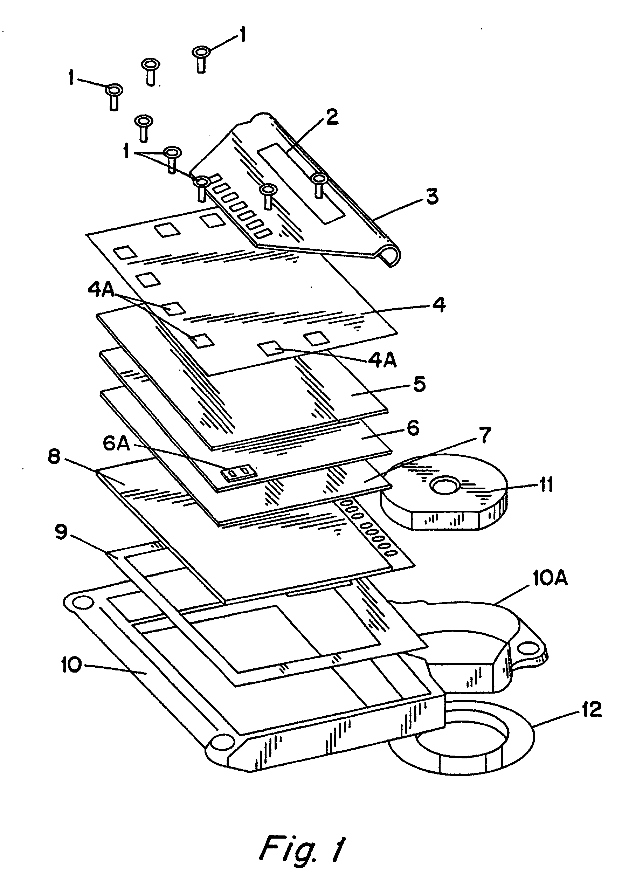

Fig. 1 presents an exploded, perspective view of a first embodiment of a liquid crystal display assembly according to a first embodiment of the present invention. In brief overview, and referring to Fig. 1, a liquid crystal display assembly includes a liquid crystal display 8, an electro luminescent film 6, a circuit board 4, a tape carrier package 3, and a carrier 10. Carrier 10 may optionally be adapted to retain speaker 11 coupled with gasket 12. Each of these components are discussed in greater detail below.

The respective components are bonded together by an adhesive layer (e.g., 5, 7, 9) to create a single fixed and compact sub-assembly. In alternate embodiments, the individual components may be connected by snap lock mechanisms or any other physical coupling technique that couples the components together to create a single fixed and compact sub-assembly. The particular mechanism for connecting the respective components of the assembly is not critical to the present invention.

Liquid crystal display 8 may be of conventional design and includes a display panel coupled to a circuitry panel comprising a plurality of electrical contacts for receiving electrical signals to activate particular regions of the display.

An adhesive film 7 secures an electro luminescent film 6 to the 'back' side of the liquid crystal display to provide backlighting for the display. Electro luminescent film 6 is of conventional construction and includes an electrical connection with circuit board 4, which can be designed in various ways (e.g, connector tab 6A may be adapted to fold over circuit board 4). Alternatively, electrical connector tab 6A may make direct contact with an electrical connector of the electronic device to which the display assembly is attached. In this alternate embodiment, circuit board 4 requires two connectors, one which connects to the electro luminescent film 6 and another which connects to the printed circuit board of the electronic device. In yet another embodiment, the tape carrier package 3 may establish an electrical connection between the electro luminescent film 6 and circuit board 4.

Adhesive film 5 may be used to secure electro luminescent film to circuit board 4. In the embodiment depicted in Fig. 1, circuit board 4 is a conventional printed circuit board formed from a suitable dielectric material (e.g., an epoxy or polymer resin) and comprising electrical circuitry for directing electrical signals to liquid crystal display 8. In an alternate embodiment, as discussed below, circuit board 4 may be a flexible circuit board formed with a suitable tape or foil. Circuit board 4 further comprises a plurality of electrical contact pads 4A that may be used to establish electrical connections between the circuit board 4 and the printed circuit board of an electronic device to which the liquid crystal display assembly is secured. To effect this connection, suitable electrically conductive contacting devices 1 are coupled to contact pads 4A of circuit board 4. Suitable contacting devices 1 may include, without limitation, springs, pads, sockets, pins, or conductive elastomeric pads of a printed circuit board of an electronic device (not shown), such as a mobile telephone, personal digital assistant, pager, or other communication device.

Contact devices 1 may be coupled to circuit board 4 using conventional techniques (e.g., soldering, mechanical connectors, or pressure-fit connections). In one embodiment of the invention, circuit board 4 includes eight gold-plated contact pads 4A and eight springs, having a with a force, e.g., of 0.5-0.7 N each, function as contact devices. This arrangement is advantageous because the springs also provide physical support (in the z-direction) for the liquid crystal display assembly during the lifetime of the electronic device. This arrangement is also advantageous because it requires only the circuit board 4 to be physically connected to the printed circuit board of the electronic device in order for the entire LCD/backlighting package to operate.

The sub-assembly of the liquid crystal display 8, electro luminescent film 6, and circuit board 4 is attached to a tape carrier package 3. Tape carrier package 3 is formed from a suitably flexible dielectric material (e.g., polymer, epoxy). Tape carrier package 3 includes a liquid crystal display driver 2 connected to electrical circuitry for establishing electrical connections between circuit board 4 and liquid crystal display 8. Liquid crystal display driver 2 may be of conventional design and includes logic circuitry for generating the electrical signals required to power the liquid crystal display. Tape carrier package 3 preferably includes electrical connectors adapted to connect with the electrical connectors on liquid crystal display 8. Tape carrier package 3 may be physically connected to the sub-assembly using conventional techniques such as, for example, heat sealing the tape carrier package to liquid crystal display 8 by folding an edge of tape carrier package 3 over the various components and forming an electrical connection with connectors on liquid crystal display 8. In addition, tape carrier package 3 is coupled, via e.g., a heat seal, to the circuit board 4, thereby forming an electrical connection with corresponding electrical connectors on the PCB 4. A liquid crystal display driver circuit 2 is mounted on the tape carrier package 3 and communicates with liquid crystal display 8 via the electrical circuitry of tape carrier package 3. Alternatively, the liquid crystal display driver circuit 2 may be coupled directly to the liquid crystal display. In sum, the tape carrier package 3 provides an electrical connection between the printed circuit board 4 via the driver circuit 2 to the liquid crystal display 8.

In an exemplary embodiment of the present invention, the above arrangement is positioned in an LCD carrier 10 and is coupled to the carrier via an adhesive layer 9. Carrier 10 may be formed from a suitably rigid material (e.g., a suitable polymer, metal, or composite material) using conventional manufacturing techniques. Additional, or alternate, securing mechanisms (e.g., mechanical fasteners, snap-fittings, etc.) may be used to facilitate securing the various components of the assembly to carrier 10. In the embodiment depicted in Fig. 1, carrier 10 further comprises a retainer 10A for housing a speaker 11. A suitable gasket 12 may be used to secure speaker 11 within retainer 10A. Carrier 10 maybe secured to an electronic device by suitable mechanisms, including mechanical or chemical fasteners.

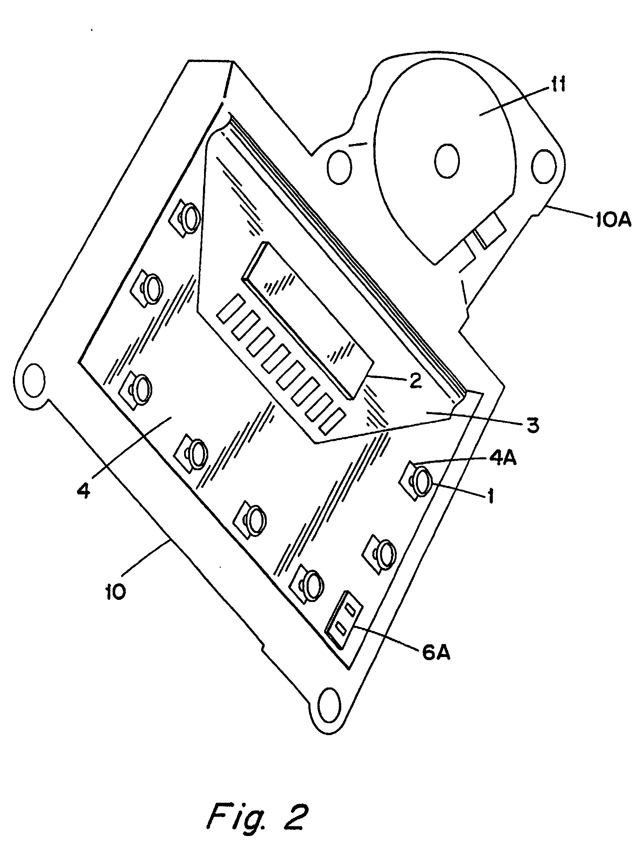

Fig. 2 presents a perspective view of an assembled liquid crystal display assembly according to the embodiment depicted in Fig. 1. Referring to Fig. 2, it can be seen that the liquid crystal display assembly is retained securely within carrier 10. Contact devices 1 are positioned to establish electrical contact with an underlying circuit board on the electronic device. Further, electrical connector tab 6A and liquid crystal driver circuit 2 are visible.

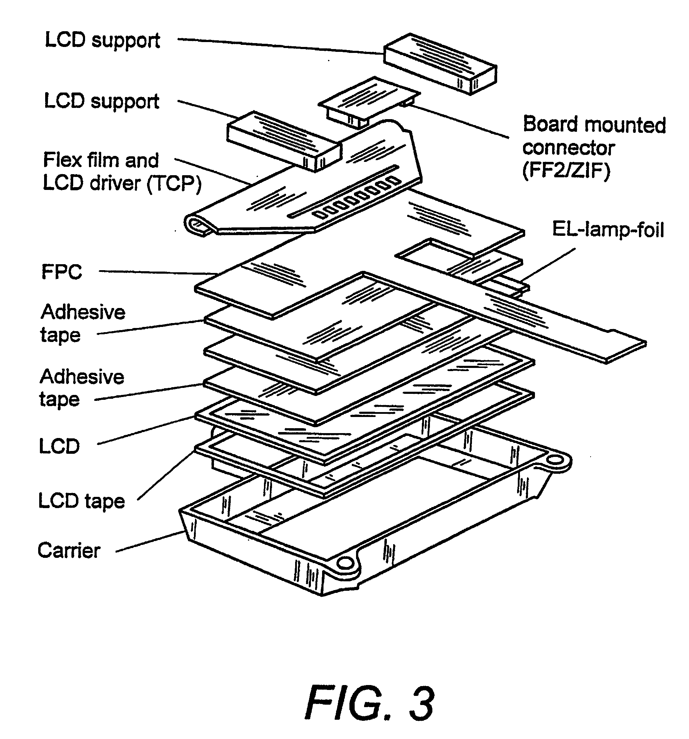

Fig. 3 presents an exploded, perspective view of a second embodiment of a liquid crystal display assembly in accordance with aspects of the present invention. The majority of the components of the assembly depicted in Fig. 3 are substantially similar as those depicted in Fig. 1. The discussion pertaining to these components will not be repeated.

In brief, liquid crystal display assembly includes a liquid crystal display 310 secured to an electro luminescent film 320, which is secured to a flexible printed circuit board 330. The respective components may be secured using adhesive films 302, 304. Tape carrier package 340 includes liquid crystal display driver circuit 342 and associated electrical circuitry for establishing an electrical connection between flexible circuit board 330 and liquid crystal display 310. The sub-assembly is secured to carrier 350 using adhesive film 306.

Flexible circuit board 330 may be connected directly to the circuit board of the electronic device to which liquid display assembly is attached. Flexible circuit board 330 contains a plurality of electrical leads for establishing an electrical connection between the liquid crystal display assembly and the circuit board of an electronic device. In one embodiment, flexible circuit board 330 includes eight (8) leads. The electrical leads of flexible printed circuit board 330 may be soldered to the circuit board of the electronic device and the flexible printed circuit board may be glued, taped or otherwise mechanically secured to the liquid crystal display assembly. A suitable connector (e.g. an FF2/ZIF connector) 360 may be provided to secure the assembly to the printed circuit board of the electronic device. Connector 360 may be soldered to the printed circuit board of the electronic device to establish a suitable mechanical and/or electrical connection. Additionally, elastomeric LCD supports 370 may be used to support the assembly on the printed circuit board of the electronic device.

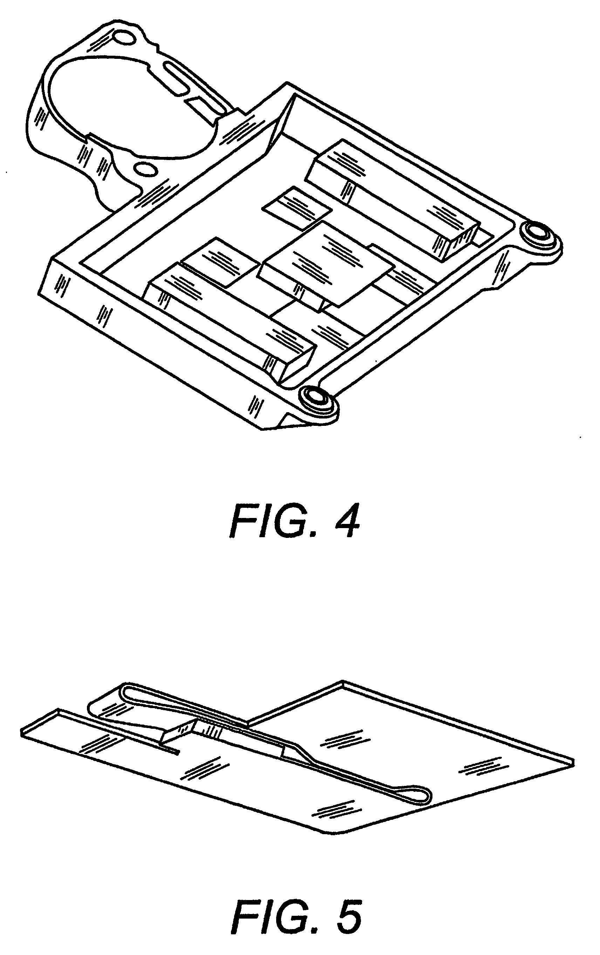

Fig. 4 presents a schematic depiction of an assembled liquid crystal display assembly according to the embodiment depicted in Fig. 3. Referring to Fig. 4, it can be seen that the liquid crystal display assembly is retained securely within carrier 350. Fig. 5 illustrates the manner in which the tongue of the flexible printed circuit may be folded over upon itself to effect an electrical connection with the printed circuit board of the electronic device.

The present invention has many advantages over existing LCD/backlighting assemblies. The present invention allows large tolerances on the interconnection LCD/backlighting package and the printed circuit board of the electronic device. Another advantage is that there exists only one connection between the EL and the LCD. The single package assembly simplifies the automatic assembly of the electronic device. The single package also makes it easy to handle the LCD/backlighting package. In addition, the single package will be robust toward mechanical stresses in the electronic device. The interconnection is very reliable and easy to mount

In addition, an advantage to having the LCD/backlighting package as a single unit is that the package can be removed and replaced from the electronic device easily in the event of failure or damage.

Additional advantages include a very efficient use of volume by having a reduced thickness and increased active area from known assemblies. The single package assembly is less sensitive to cosmetic defects caused by dust and dampness. The present invention has a superior performance since the EL film is well defined over the area and the LCD works with a low impedance connection. In addition, the EL film fixation provides the EL film with good acoustic performance.

## Claims

1. A liquid crystal display assembly, comprising:
a carrier (10);
a liquid crystal display (8) secured adjacent the carrier (10);
an electro luminescent film (6) secured adjacent the liquid crystal display (8);
a circuit board assembly (4) secured adjacent the electro luminescent film (6); and
a tape carrier package (3) secured adjacent the circuit board assembly (4) and including circuitry for establishing an electrical connection between the liquid crystal display (8) and the circuit board assembly (4); **characterised in that** said tape carrier package (3) has a liquid crystal display driver circuit (2). mounted to it for generating electrical signals to power the liquid crystal display (8).

2. A liquid crystal display assembly according to claim 1, wherein:
the circuit board assembly (4) comprises a rigid printed circuit board.

3. A liquid crystal display assembly according to claim 2, wherein:
the rigid printed circuit board comprises a plurality of contact plates (4A) for receiving a plurality of spring connectors (1) operative to provide an electrical connection to a printed circuit board of an electronic device.

4. A liquid crystal display assembly according to claim 3, wherein:
the plurality of spring connectors (1) each provides a compressive force that measures between 0.5 and 0.7 newtons to support the liquid crystal display assembly in position with respect to the printed circuit board of the electronic device.

5. A liquid crystal display assembly according to claim 1, wherein:
the circuit board assembly (4) comprises a flexible printed circuit board (330).

6. A liquid crystal display assembly according to claim 5, wherein:
the flexible circuit board (330) comprises a flexible connector member adapted to fold over portions of the tape carrier package and including circuitry for establishing an electrical connection with driver drcuitry connected to the tape carrier package.

7. A liquid crystal display assembly according to claim 1, wherein:
the tape carrier package (3) further includes circuitry for establishing an electrical connection between the electro luminescent film (6) and the circuit board assembly (4).

8. A liquid crystal display assembly according to claim 1, wherein:
the electro luminescent film (6) assembly is secured to the liquid crystal display (8) using an optically transparent adhesive film.

9. A liquid crystal display assembly according to claim 1, wherein:
the circuit board assembly (4) is secured to the electro luminescent film (6) by an adhesive film.

10. A liquid crystal display assembly according to claim 1, wherein:
the carrier (10) comprises a housing (10A) for receiving a speaker.

11. A method of assembling a liquid crystal display assembly, comprising the steps of:
providing a liquid crystal display (8);
adhering an electro luminescent film (6) to a first side of the liquid crystal display (8);
adhering a circuit board (4) to the electro luminescent film (6), the circuit board (4) having electrical connections for providing electrical signals to the liquid crystal display (8); and
securing a tape carrier package (3)adjacent the circuit board, the tape carrier package having circuitry for establishing an electrical connection between the liquid crystal display (8) and the circuit board (4), **characterised in that** said tape carrier package has a liquid crystal display driver (2) mounted to it for generating electrical signals to power the liquid crystal display (8).

12. The method of claim 11, further comprising the step of:
securing a carrier (10) to a second side of the liquid crystal display (8), the carrier (10) defining a housing attachable to an electronic device.

13. The method of claim 11, wherein the circuit board is a rigid printed circuit board (4), and further comprising the step of:
securing springs (1) to the rigid printed circuit board (4).

14. The method of claim 11, wherein the circuit board is a flexible circuit board (330) having a flexible connector member, further comprising the step of:
folding the flexible connector member over portions of the tape carrier package (340) to establish an electrical connection between the liquid crystal display (310) and the circuit board (330).

## Patentansprüche

1. Flüssigkristallanzeigeanordnung umfassend:
- einen Träger (10);
- eine Flüssigkristallanzeige (8) angrenzend an den Träger (10) befestigt;
- eine Elektroluminiszenzschicht (6), angrenzend an die Flüssigkristallanzeige (8) befestigt;
- eine Leiterplattenanordnung (4), angrenzend an die Elektroluminiszenzschicht (6) befestigt; und
- eine Bandträgeranordnung (3), die angrenzend an die Leiterplattenanordnung (4) befestigt ist und eine Schaltungsanordnung zum Einrichten einer elektrischen Verbindung zwischen der Flüssigkristallanzeige (8) und der Leiterplattenanordnung (4) umfasst,
**dadurch gekennzeichnet, dass**
die Bandträgeranordnung (3) eine Flüssigkristallanzeigetreiberschaltung (2) an sich montiert enthält zum Generieren elektrischer Signale zum Antreiben der Flüssigkristallanzeige (8).

2. Flüssigkristallanzeigeanordnung nach Anspruch 1, wobei die Leiterplattenanordnung (4) eine steife Leiterplatte umfasst.

3. Flüssigkristallanzeigeanordnung nach Anspruch 2, wobei die steife Leiterplatte eine Vielzahl von Kontaktflächen (4A) umfasst zum Empfangen einer Vielzahl von Federverbindern (1), wirksam zum Bereitstellen einer elektrischen Verbindung mit einer Leiterplatte einer Elektronikeinrichtung.

4. Flüssigkristallanzeigeanordnung nach Anspruch 3, wobei:
- mehrere Federverbinder (1) jeweils eine Druckkraft bereitstellen, die zwischen 0,5 und 0,7 Newton misst zum Halten der Flüssigkristallanzeigenanordnung in Position in Bezug auf die Leiterplatte der Elektronikeinrichtung.

5. Flüssigkristallanzeigeanordnung nach Anspruch 1, wobei:
- die Leiterplattenanordnung (4) eine flexible Leiterplatte (330) umfasst.

6. Flüssigkristallanzeigeanordnung nach Anspruch 5, wobei die flexible Leiterplatte (330) ein flexibles Verbindungsteil einschließt, eingerichtet, um Abschnitte der Bandträgeranordnung zu umwickeln und eine Schaltung einschließend zum Einrichten einer elektrischen Verbindung mit einer mit der Bandträgeranordnung verbundenen Treiberschaltungsanordnung.

7. Flüssigkristallanzeigeanordnung nach Anspruch 1, wobei:
die Bandträgeranordnung (3) außerdem eine Schaltung umfasst zum Einrichten einer elektrischen Verbindung zwischen der Elektroluminiszenzschicht (6) und der Leiterplattenanordnung (4).

8. Flüssigkristallanzeigeanordnung nach Anspruch 1, wobei:
die Elektroluminiszenzschichtanordnung (6) an der Flüssigkristallanzeige (8) befestigt ist unter Verwendung eines optisch transparenten Klebefilms.

9. Flüssigkristallanzeigeanordnung nach Anspruch 1, wobei:
die Leiterplattenanordnung (4) an der Elektroluminiszenzschicht (6) befestigt ist durch einen Klebefilm.

10. Flüssigkristallanzeigeanordnung nach Anspruch 1, wobei:
der Träger (10) ein Gehäuse (10A) umfasst zum Aufnehmen eines Lautsprechers.

11. Verfahren des Zusammenbauens einer Flüssigkristallanzeigeanordnung, die Schritte umfassend:
Bereitstellen einer Flüssigkristallanzeige (8);
Anhaften einer Elektroluminiszenzschicht (6) an einer ersten Seite der Flüssigkristallanzeige (8);
Anhaften einer Leiterplatte (4) an der Elektroluminiszenzschicht (6), wobei die Leiterplatte (4) elektrische Verbindungen hat zum Bereitstellen elektrischer Signale zu der Flüssigkristallanzeige (8); und
Befestigen einer Bandträgeranordnung (3) angrenzend an die Leiterplatte, wobei die Bandträgeranordnung eine Schaltung umfasst zum Einrichten einer elektrischen Verbindung zwischen der Flüssigkristallanzeige (8) und der Leiterplatte (4),
**dadurch gekennzeichnet, dass** die Bandträgeranordnung einen Flüssigkristallanzeigetreiber (2) an sich montiert hat zum Generieren elektrischer Signale zum Antreiben der Flüssigkristallanzeige (8).

12. Verfahren nach Anspruch 11, außerdem den Schritt umfassend:
Befestigen eines Trägers (10) an einer zweiten Seite der Flüssigkristallanzeige (8), wobei der Träger 10 ein an einer Elektronikeinrichtung anbringbares Gehäuse definiert.

13. Verfahren nach Anspruch 11, wobei die Leiterplatte eine steife Leiterplatte (4) ist und außerdem den Schritt umfassend:
Befestigen von Federn (1) an der steifen Leiterplatte (4).

14. Verfahren nach Anspruch 11, wobei die Leiterplatte eine flexible Leiterplatte (330) ist mit flexiblem Verbindungsteil, außerdem den Schritt umfassend:
Falten des flexiblen Verbindungsteils über Abschnitte der Bandträgeranordnung (340) zum Einrichten einer elektrischen Verbindung zwischen der Flüssigkristallanzeige (310) und der Leiterplatte (330).

## Revendications

1. Ensemble d'écran à cristaux liquides comprenant :
un support (10) ;
un écran à cristaux liquides (8) fixé dans une position adjacente au support (10) ;
un film électroluminescent (6) fixé dans une position adjacente à l'écran à cristaux liquides (8) ;
un ensemble de cartes à circuit imprimé (4) fixé dans une position adjacente au film électroluminescent (6) ; et
un assemblage porteur de bande (3) fixé dans une position adjacente à l'ensemble de cartes à circuit imprimé (4) et incluant des circuits permettant d'établir une connexion électrique entre l'écran à cristaux liquides (8) et l'ensemble de cartes à circuit imprimé (4) ; **caractérisé en ce que** l'assemblage porteur de bande (3) comporte un circuit de commande (2) d'écran à cristaux liquides, monté sur ledit assemblage porteur de bande (3) pour générer des signaux électriques afin de commander l'alimentation de l'écran à cristaux liquides (8).

2. Ensemble d'écran à cristaux liquides selon la revendication 1, dans lequel :
l'ensemble de cartes à circuit imprimé (4) comprend une carte à circuit imprimé rigide.

3. Ensemble d'écran à cristaux liquides selon la revendication 2, dans lequel :
la carte à circuit imprimé rigide comprend une pluralité de plots de contact (4A) pour recevoir une pluralité de connecteurs à ressort (1) agencés pour créer la connexion électrique d'une carte à circuit imprimé d'un dispositif électronique.

4. Ensemble d'écran à cristaux liquides selon la revendication 3, dans lequel :
chaque connecteur de la pluralité de connecteurs à ressort (1) fournit une force de compression de 0,5 à 0,7 newtons afin de maintenir l'ensemble d'écran à cristaux liquides en place par rapport à la carte à circuit imprimé du dispositif électronique.

5. Ensemble d'écran à cristaux liquides selon la revendication 1, dans lequel :
l'ensemble de cartes à circuit imprimé (4) comprend une carte à circuit imprimé flexible (330).

6. Ensemble d'écran à cristaux liquides selon la revendication 5, dans lequel :
la carte à circuit imprimé flexible (330) comprend un organe connecteur flexible adapté pour se plier sur des portions de l'assemblage porteur de bande et incluant des circuits permettant d'établir une connexion électrique avec le circuit de commande connecté à l'assemblage porteur de bande.

7. Ensemble d'écran à cristaux liquides selon la revendication 1, dans lequel :
l'assemblage porteur de bande (3) comprend en outre des circuits pour établir une connexion électrique entre le film électroluminescent (6) et l'ensemble de cartes à circuit imprimé (4).

8. Ensemble d'écran à cristaux liquides selon la revendication 1, dans lequel :
l'ensemble de film électroluminescent (6) est fixé sur l'écran à cristaux liquides (8) au moyen d'un film adhésif optiquement transparent.

9. Ensemble d'écran à cristaux liquides selon la revendication 1, dans lequel :
l'ensemble de cartes à circuit imprimé (4) est fixé sur le film électroluminescent (6) au moyen d'un film adhésif.

10. Ensemble d'écran à cristaux liquides selon la revendication 1, dans lequel :
le support (10) comprend un logement (10A) destiné à recevoir un haut-parleur.

11. Procédé d'assemblage d'un ensemble d'écran à cristaux liquides, comprenant les étapes consistant à :
fournir un écran à cristaux liquides (8) ;
coller un film électroluminescent (6) sur un premier côté de l'écran à cristaux liquides (8) ;
coller une carte à circuit imprimé (4) sur le film électroluminescent (6), la carte à circuit imprimé (4) ayant des connexions électriques destinées à fournir des signaux électriques à l'écran à cristaux liquides (8) ; et
fixer un assemblage porteur de bande (3) dans une position adjacente à la carte à circuit imprimé, l'assemblage porteur de bande comportant des circuits permettant d'établir une connexion électrique entre l'écran à cristaux liquides (8) et
la carte à circuit imprimé (4), **caractérisé en ce que** ledit assemblage porteur de bande comporte un circuit de commande (2) d'écran à cristaux liquides, monté sur l'assemblage porteur de bande, pour générer des signaux électriques afin de commander l'alimentation de l'écran à cristaux liquides (8).

12. Procédé selon la revendication 11, comprenant en outre l'étape consistant à :
fixer un support (10) sur un deuxième côté de l'écran à cristaux liquides (8), le support (10) définissant un logement pouvant être fixé à un dispositif électronique.

13. Procédé selon la revendication 11, dans lequel la carte à circuit imprimé est une carte à circuit imprimé (4) rigide, et comprenant en outre l'étape consistant à :
fixer des ressorts (1) sur la carte à circuit imprimé (4) rigide.

14. Procédé selon la revendication 11, dans lequel la carte à circuit imprimé est une carte à circuit imprimé (330) flexible munie d'un organe connecteur flexible, comprenant en outre l'étape consistant à :
plier l'organe connecteur flexible sur des portions de l'assemblage porteur de bande (340) pour établir une connexion électrique entre l'écran à cristaux liquides (310) et la carte à circuit imprimé (330).
